Europäisches Patentamt

European Patent Office

Office européen des brevets

Publication number: **0 367 729**
**A2**

# EUROPEAN PATENT APPLICATION

Application number: **89830446.4**

Date of filing: **16.10.89**

Int. Cl.5: **H01L 21/76** , **H01L 21/225**

Priority: **03.11.88 IT 8367588**

Date of publication of application:
**09.05.90 Bulletin 90/19**

Designated Contracting States:
**DE FR GB NL SE**

Applicant: **SGS-THOMSON**
**MICROELECTRONICS s.r.l.**
**Via C. Olivetti, 2**
**I-20041 Agrate Brianza Milano(IT)**

Inventor: **Bellezza, Orio**
**Via Terzi S. Agata, 2**
**I-24035 Curno(IT)**

Representative: **Pellegri, Alberto et al**
**c/o Società Italiana Brevetti S.p.A. Via**
**Cavour, 9**
**I-21100 Varese(IT)**

**Process for forming trench isolation structures in a silicon substrate for CMOS and NMOS devices.**

Formation of a P+ channel-stop diffused region adjacent to substantially vertical lateral walls of trenches etched in the silicon for forming BOX isolation structures in CMOS and NMOS devices is achieved by growing a thermal oxide barrier layer on the silicon walls within the trench, depositing a BSG dopant source layer by CVD techniques, thermally diffusing dopant atoms from the source layer through the thermal oxide barrier layer into the silicon substrate for producing the desired diffused region adjacent to the trench's walls. The dopant source layer and the thermal oxide barrier layer are removed thereafter and the fabrication process may proceed in an usual way.

FIG. 1

FIG.3

EP 0 367 729 A2

# PROCESS FOR FORMING TRENCH ISOLATION STRUCTURES IN A SILICON SUBSTRATE FOR CMOS AND NMOS DEVICES

## BACKGROUND OF THE INVENTION

### 1. Field of the invention

The present invention relates to an improved process for fabricating CMOS and NMOS integrated semiconductor devices and, more in particular, to a process for forming trench isolation structures among active components in the semiconducting substrate.

### 2. Description of the Prior Art

Various techniques have been developed and perfected for forming electrical isolation regions among active components integrated on the same monolithic semiconducting substrate. The different techniques for forming such isolation structures have a fundamental importance in achieving a large scale of integration. In particular so-called BOX (an acronym for Buried Oxide) isolation techniques have been developed, which are based on forming trenches relatively deep in the monocrystalline silicon substrate by anisotropic etching techniques and on filling these trenches with a dielectric material, e.g. silicon oxide, generally deposited by means of chemical vapour deposition (CVD) techniques, and on a subsequent planarization of the wafer front surface in order to obtain a substantially flat substrate. The advantage of this BOX isolation technology versus more traditional technologies such as the LOCOS technique, is represented essentially by the absence of any "bird's beak" appendices along the tapered sides of the thick isolation oxide layer or field oxide.

On the other hand, N-channel MOSFET transistors fabricated by the BOX isolation technique are known to show "shoulders" in the below-threshold current characteristic and an inverted narrow channel effect affecting the threshold voltage. These disadvantages arising from using the BOX isolation technique in CMOS and NMOS integrated devices, may be overcome, as divulged in recent literature, by purposely creating P + diffusions with a dopant concentration comprised between $10^{16}$ . and $10^{17}$ atoms/cm$^3$ (also known as channel-stop diffusions) in the substrate directly adjacent to the walls of the isolation trench to be filled with dielectric material.

The fact that the isolation trenches cut into the silicon must be, for obvious reasons, relatively deep and narrow, causes remarkable problems to the formation of such lateral P + diffusions. A technique used is that of pre-forming a deep P + diffusion within which the silicon is thereafter etched. More recently, it has been proposed to form the trenches with an etching technique capable of producing a tapered trench's cross section. This technique makes easier to dope the side walls of the trench with a reduced implantation dose besides reducing the encroaching by diffusion of the dopant species into the active region of the integrated device, however the tapering of the side walls of the isolation trench reduces the effective separation distance among adjacent integrated devices and may cause degradation of the isolation characteristics and in general trenches with substantially vertical side walls are reputed more advantageous than tapered side walls trenches for achieving high densities of integration. Another alter native known technique is that of effecting implantation of the dopant in two or three consecutive steps conducted with the wafer inclined in respect to the ion beam direction and by rotating the supported wafer after each step in order to offer to the impinging ion beam one and the other of the trench's side walls and eventually the trench's bottom surface.

A further known proposal is that of sequentially forming inside the trench an inclined surface facing the vertical side wall of the trench and capable of deflecting a portion of the accelerated ions in a direction substantially perpendicular to the side wall to be implanted.

All these techniques directed to promote the implantation of dopant atoms coming from a strongly directional beam of accelerated ions on the side walls of relatively deep and narrow trenches etched on the surface of the wafer are relatively difficult and hardly capable of ensuring a good result with varying operating conditions.

It is further known from the publication WO 86/04454 a method of boron doping silicon through the vertical side walls of trenches etched in the silicon by forming a layer of silicon oxide having a thickness comprised between 100 and 500 Angstroms, depositing over this diffusion control layer a source layer of polycrystalline silicon of a thickness of about 4000 Angstroms and doping the polycrystalline silicon with boron at a concentration comprised between $1 \times 10^{16}$ and $1 \times 10^{20}$ atoms/cm$^3$ and by heat treating at 950$^\circ$ C in steam for favouring the diffusion of boron through the layer of silicon oxide into the silicon to be doped and the concomitant oxidation of part of the thickness of the doped polycrystalline silicon layer. The method is difficult to control because of boron

segregation phenor ɔna at the deepening oxidation interface.

OBJECTIVE AND SUMMARY OF THE INVENTION

Objective of the present invention is a process for boron doping (P +) substantially vertical side walls of trenches etched in a semiconducting monocrystalline silicon substrate for forming encased (BOX) isolation structures in a relatively simple and intrinsically reliable manner.

The process of the invention for boron doping (P +) side walls of trenches etched in a P-type silicon substrate contemplates growing a thermal oxide barrier layer at least on the walls to be doped by oxidizing the substrate silicon until obtaining an oxide layer having a thickness preferably comprised between 5 and 15 nanometers (nm);

depositing a source layer of a boron and silicon mixed oxides glass (BSG) having a boron content lower than or equal to 1% by weight at least over the walls to be doped previously coated with said barrier thermal oxide;

diffusing boron atoms from the source layer through the thermal oxide barrier layer into the substrate silicon by heating for a time sufficient to produce in the silicon a P + diffused region adjacent to the walls to be doped; and

etching off said source layer and said thermal oxide barrier layer.

It has been found that by keeping the boron concentration in the mixed oxide source layer below or equal to 1% by weight and by utilizing a barrier layer of silicon oxide, thermally grown on the surface of the silicon to be doped to a thickness from 5 to 15 nm, the boron diffusion from the source layer into the silicon through the thermal oxide barrier layer is extremely easy to control and shows very good reproducibility characteristics. Under these aspects the process of the present invention has remarkable advantages in respect to the known processes.

The process of the invention is useful for fabricating NMOS devices as well as CMOS devices (N-Well, P-Well or Twin-Tub type). Similarly to the prior art techniques, in case of CMOS fabrication processes, also the process of the invention contemplates the use of the so-called "P isolation mask" for carrying out the boron doping of the side walls of the isolation trenches solely on P-type active areas.

The process of the invention may be carried out without requiring important modifications of a normal sequence of steps of a fabrication process of these types of integrated devices. With the exception of the peculiar steps which characterize the process of the invention, all other process steps may be carried out according to usual procedures.

BRIEF DESCRIPTION OF THE DRAWINGS

**Figures from 1 to 3** show the essential steps of the process of the present invention as applied to an N-Well CMOS process.

DESCRIPTION OF THE PREFERRED EMBODIMENT

Essentially, for an N-Well CMOS process the basic sequence of process steps will be the following:

1. formation of N-Well deep diffusions (2) in a P-type monocrystalline silicon substrate (1) by means of conventional techniques;

2. growth on the surface of the substrate of an initial oxide layer (3) having a thickness comprised between about 5 and 100 nm, by conventional techniques;

3. deposition of a silicon nitride layer (4) having a thickness comprised between about 90 and 300 nm, by conventional techniques;

4. definition of the geometry of the two stacked layers (4 + 3), by conventional lithographic techniques and subsequent etching of the two stacked layers (4 + 3) on unmasked areas until exposing the silicon substrate, by means of conventional techniques;

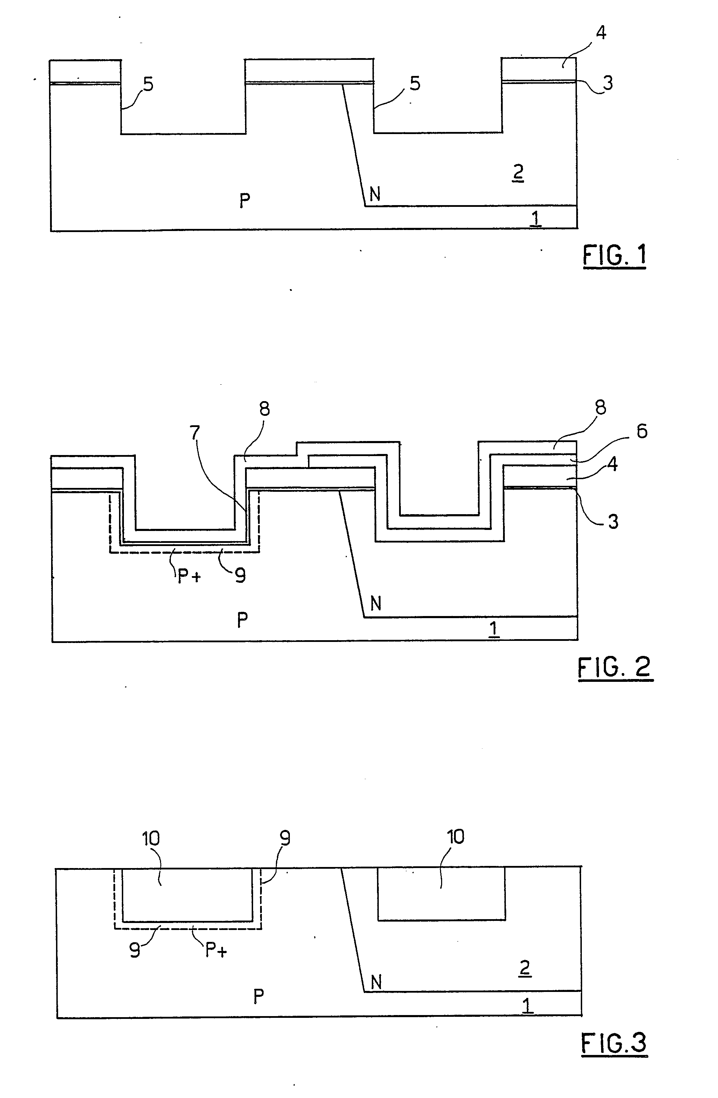

5. etching of the substrate silicon by dry or wet etching techniques in order to form trenches (5) with substantially vertical side walls, by conventional techniques (the fragmentary section of the device being fabricated at this point of the process is depicted in Fig. 1);

6. deposition of a silicon oxide layer (6) having a thickness comprised between about 50 and 500 nm, by conventional techniques, e.g. CVD;

7. definition of a desired geometry of the layer (6) of deposited oxide and etching of the deposited oxide until a complete removal from P-type areas;

8. growth of a thermal oxide barrier layer (7) having a thickness comprised between 5 and 15 nm by oxidizing the silicon on the exposed areas (i.e. into the trenches (5) in P-type areas);

9. deposition of a dopant source layer (8) of a boron and silicon mixed oxide (BSG) having a boron content lower than or equal to 1% by weight, by conventional CVD techniques;

10. controlled heat treatment for diffusing boron from the BSG source layer (8) deposited on the walls of the trench into the P-type silicon of the substrate to form a P+-type diffused region (9) immediately adjacent to the trench's walls (a fragmentary section of the device being fabricated at this point of the process is depicted in Fig.2);

11. removal of the BSG source layer (8) and of the barrier oxide layer (7) by anisotropic dry or wet etching treatment;

12. removal of the deposited oxide layers (6), of the nitride layer (4) and of the initial oxide layer (3), according to conventional techniques;

13. filling of trenches (5) with a dielectric material such as for example silicon oxide (10), according to conventional techniques (a fragmentary section of the device being fabricated at this point of the process is depicted in Fig. 3);

14. formation of semiconductor devices within P-type and N-type active areas defined by the isolation structures constituted by the trenches (5) filled with dielectric material and, in case of devices made in P-type silicon areas, that is in the case of N-channel devices, by the channel-stop diffusion (9) formed according to the above described process of the instant invention.

All the significant process variables of the peculiar steps of the process of the invention for forming the P+ diffusion adjacent to the walls of the isolation trench, such as the boron concentration in the BSG mixed oxide source layer, the thickness of the thermal oxide barrier layer (7), the temperature and duration of the heat treatment for diffusing boron from the source layer, through the thin thermal oxide barrier layer, into the silicon, are notably easily controlled without difficulties. For fabricating NMOS devices the sequence of steps of the process of the invention may be the same as described above for N-Well CMOS devices with the exclusion of the steps 1, 6, 7, 12 and 13.

## Claims

1. A process for boron doping substantially vertical side walls of trenches etched in a semiconducting monocrystalline silicon substrate for forming isolation structures encased in the substrate, which comprises

growing a thermal oxide barrier layer over the walls to be doped by oxidizing the substrate monocrystalline silicon until a layer of oxide having a thickness comprised between 5 and 15 nm is formed thereon;

depositing a dopant source layer of a boron and silicon mixed oxide having a boron content lower than or equal to 1% by weight at least on the walls to be boron doped;

diffusing boron atoms from said source layer, through said thermal oxide barrier layer, into said monocrystalline silicon by heating for a time sufficient to form a boron diffused region in the silicon adjacent to said walls; and

removing said source layer and said barrier layer.

FIG. 1

FIG. 2

FIG.3